**Europäisches Patentamt**

**European Patent Office**

**Office européen des brevets**

(11) Veröffentlichungsnummer: **0 057 253**
**B1**

(12) **EUROPÄISCHE PATENTSCHRIFT**

(45) Veröffentlichungstag der Patentschrift:
**27.02.85**

(21) Anmeldenummer: **81107910.2**

(22) Anmeldetag: **05.10.81**

(51) Int. Cl.⁴: **H 01 L 23/48**

(54) **Systemträgerband mit mehreren Systemträgern für integrierte Schaltkreise.**

(30) Priorität: **02.02.81 DE 3103454**

(43) Veröffentlichungstag der Anmeldung:
**11.08.82 Patentblatt 82/32**

(45) Bekanntmachung des Hinweises auf die Patenterteilung:
**27.02.85 Patentblatt 85/9**

(84) Benannte Vertragsstaaten:
**FR GB IT NL SE**

(56) Entgegenhaltungen:
**EP - A - 0 016 522**
**US - A - 4 012 766**

(73) Patentinhaber: **VDO Adolf Schindling AG,
Gräfstrasse 103, D-6000 Frankfurt/Main (DE)**

(72) Erfinder: **Tresky, Miroslav, Dr., Tödistrasse 106,
CH-8800 Thalwill (CH)**
Erfinder: **Buck, Raymond Herbert, Dr., Hölderlinweg 22d,
D-6380 Bad Homburg (DE)**

(74) Vertreter: **Könekamp, Herbert, Dipl.-Ing., Sodener
Strasse 9, D-6231 Schwalbach (DE)**

ACTORUM AG

## Beschreibung

Die Erfindung bezieht sich auf ein Systemträgerband mit mehreren mit Abstand in Bandlängsrichtung hintereinander angeordneten Systemträgern für integrierte Schaltkreise, von denen jeder aus einer Anzahl von Leiterbahnen besteht, die sich von einem dem integrierten Schaltkreis zugeordneten inneren Bereich strahlenartig zu einem äusseren, Anschlussflächen aufweisenden Bereich erstreckenden, zwischen dem und der ihm benachbarten Bandkante ein dem Transport des Bandes während der Fertigung dienender Bandrandbereich vorhanden ist.

Es sind bereits Systemträger für integrierte Schaltkreise bekannt, die aus einem folienartigen Isolierstoffsubstrat bestehen, auf dem die Leiterbahnen des Systemträgers aufgebracht sind. Die Herstellung derartiger Systemträger erfolgt, wenn sie in grossen Stückzahlen benötigt werden, in einem kontinuierlichen Fotoätzverfahren aus einem metallkaschierten Isolierstoffband oder in einem kontinuierlichen Siebdruckverfahren. Das Systemträgerband durchläuft hierbei mehrere Fertigungsstufen, wobei es im allgemeinen nach Art eines Films transportiert wird und infolgedessen in seinen beiden Randbereichen eine Perforation aufweist.

Es sind des weiteren Systemträgerbänder bekannt, bei denen die einzelnen Systemträger unmittelbar und ohne ein Isolierstoffband miteinander verbunden sind und das gesamte Systemträgerband also vollständig aus Metall besteht.

Das Systemträgerband stellt, wie sein Aufbau auch immer gewählt ist, eine Art Halbfabrikat dar. Nach dem Verlöten oder, was im allgemeinen aus fertigungstechnischen Gründen bevorzugt wird, Verschweissen der Leiterbahnen mit dem integrierten Schaltkreis und gegebenenfalls der Aufbringung einer Kunststofffixierung – beides erfolgt ebenfalls in einem kontinuierlich ablaufenden Prozess, währenddessen das Systemträgerband ebenfalls filmartig transportiert wird – wird der Systemträger aus dem Systemträgerband herausgestanzt, und anschliessend können an die äusseren Anschlussflächen die Verbindungsleitungen für die anderen Schaltungselemente angelötet oder angeschweisst werden.

Es hat sich nun gezeigt, dass, insbesondere beim Verschweissen der Leiterbahnen mit dem integrierten Schaltkreis in einem einzigen Arbeitsgang, ein in jüngster Zeit immer häufiger angewandtes Arbeitsverfahren, das die Herstellung grosser Stückzahlen von mit Systemträgern versehenen integrierten Schaltkreisen erlaubt, einzelne Leiterbahnen nur unvollkommen mit dem integrierten Schaltkreis verbunden sind, insofern, als sie sich bereits nach einem Auf- und Abwickelvorgang des mit den integrierten Schaltkreisen versehenen Systemträgerbandes beispielsweise von einer Speicherspule von dem integrierten Schaltkreis lösen. Wie Untersuchungen gezeigt haben, handelt es sich hierbei hauptsächlich um Leiterbahnen, die sich im wesentlichen in Längsrichtung des Bandes erstrecken, jedoch kaum um quer zur Längsachse des Bandes verlaufende Leiterbahnen. Ein solches Loslösen der Leiterbahnen vom integrierten Schaltkreis könnte daher in naheliegender Weise dadurch verhindert werden, dass das Systemträgerband nach dem Aufbringen des integrierten Schaltkreises nur noch Biegungen mit grossen Biegungsradien unterworfen wird. Dies würde jedoch zu einer erheblichen Vergrösserung der Fertigungsanlagen und zu wegen ihrer Grösse schwierig zu handhabenden Speicherspulen sowie zu anderen Fertigungsschwierigkeiten führen.

Die Erfindung geht zur Behebung dieser Nachteile einen anderen Weg und zwar wird erfindungsgemäss vorgeschlagen, zwischen jeweils zwei einander benachbarten Systemträgern und den beiden diesen Systemträgern zugeordneten Bandrandbereichen mindestens eine die Flexibilität des Bandes in diesem Gebiet erhöhende Ausnehmung vorzusehen. Durch die Anordnung einer oder mehrerer derartiger Ausnehmungen zwischen den Systemträgern im Systemträgerband wird eine Art Gleiskeetteneffekt erzielt: Die einzelnen Systemträger sind über die gut flexiblen Zwischenstücke gelenkartig miteinander verbunden, so dass bei einer Biegung des Bandes die einzelnen, die Systemträger aufweisenden Bandabschnitte nicht oder nur in vernachlässigbarem Umfang auf Biegung beansprucht werden, während die zwischen den Systemträgern liegenden Bereiche die gesamte Bandumlenkung zwischen zwei Systemträgern aufnehmen. Damit ist sichergestellt, dass bei einer Biegung des Bandes auf die Verbindung zwischen den Leiterbahnen des Systemträgers und den integrierten Schaltkreis einwirkende Kräfte ihrem Betrage nach so gering bleiben, dass eine Trennung der Verbindung nicht mehr stattfindet.

Gemäss einer vorteilhaften Ausführungsform der Erfindung ist in dem Gebiet zwischen zwei einander benachbarten Systemträgern und den beiden diesen Systemträgern zugeordneten Bandrandbereichen nur eine einzige Ausnehmung vorhanden, die sich von Bandrandbereich zu Bandrandbereich und von Systemträger zu Systemträger erstreckt. Normalerweise ist eine solche Ausführungsform einer anderen, ebenfalls möglichen Ausführungsform vorzuziehen, bei der zwei oder mehrere quer zur Bandlängsrichtung mit Abstand hintereinander angeordnete Ausnehmungen in dem Gebiet vorhanden sind, da eine solche Ausführungsform im allgemeinen eine etwas geringere Flexibilität aufweist als die zuvor beschriebene. Die Ausführungsform mit zwei oder mehreren Ausnehmungen in jedem Gebiet bringt jedoch den Vorteil mit sich, dass das Systemträgerband während der Fertigung mit grösseren, in Längsrichtung wirkenden Kräften beaufschlagt werden kann, als dies bei einem Systemträgerband der Fall ist, bei dem in jedem Gebiet lediglich eine einzige, sich von Bandbereich zu Bandbereich und von Systemträger zu Systemträger erstreckende Ausnehmung vorhanden ist. Eine hinsichtlich Belastbarkeit und Flexibilität zwischen den beiden vorgenannten Ausführungsformen liegende Ausführungsform besteht darin, dass mindestens zwei zueinander parallele und in Bandlängsrichtung hintereinander angeordnete Ausnehmungen in dem Gebiet vorhanden sind.

Ein weiterer Schutz der einzelnen Systemträger vor einer elastischen und/oder plastischen Verformung während der Fertigung kann nach einem weiteren Gedanken der Erfindung dadurch erreicht werden, dass jedes einem Bandrandbereich zugewandte Ausnehmungsende mindestens einen sich etwa in Bandlängsrichtung zwischen den Bandrandbereich und den Systemträger erstreckenden Ausnehmungsfortsatz aufweist. Hierdurch lässt sich der Verbindungsteil zwischen dem Systemträger und dem dem Transport des Bandes während der Fertigung dienenden Bandrandbereich und damit die Angriffsfläche der von den Bandrandbereichen auf den Systemträger wirkenden Kräfte in einem solchen Umfang vermindern, dass eine Trennung einzelner Leiterbahnen des Systemträgers vom integrierten Schaltkreis auch bei hohen Fertigungsgeschwindigkeiten und verhältnismässig kleinen Biegeradien des Systemträgerbandes sicher unterbunden sind. In Optimierung der vorgenannten Ausführungsformung empfiehlt es sich, die Länge der Ausnehmungsfortsätze dergestalt zu wählen, dass jeder Systemträger ausschliesslich über zwei schmale, quer zur Bandlängsachse verlaufende Brücken mit dem Bandrandbereich verbunden ist. Ferner hat es sich als zweckmässig erwiesen, die beiden Brücken etwa mittig zum Systemträger anzuordnen, um einerseits eine sichere Halterung des Systemträgers im Systemträgerband zu erhalten und andererseits die bei einer versetzten Anordnung der Brücken im Systemträger bei einer Biegung des Bandes eventuell auftretenden Torsionskräfte auszuschalten.

Die Erfindung sei anhand der Zeichnung, die in zum Teil schematischer Darstellung Ausführungsbeispiele enthält, näher erläutert. Es zeigen

Fig. 1 eine Aufsicht auf ein Systemträgerband bekannter Ausführungsform.

Fig. 2 eine Aufsicht auf ein Systemträgerband mit mehreren zwischen den Systemträgern angeordneten Ausnehmungen,

Fig. 3 eine Aufsicht auf ein Systemträgerband mit zwei zwischen den Systemträgern angeordneten Ausnehmungen,

Fig. 4 eine Aufsicht auf ein Systemträgerband mit einer zwischen den Systemträgern angeordneten Ausnehmung,

Fig. 5 eine Aufsicht auf ein Systemträgerband mit einer zwischen den Systemträgern angeordneten Ausnehmung mit endseitigen Verbreiterungen,

Fig. 6 eine Aufsicht auf ein Systemträgerband mit mehreren kreisförmigen Ausnehmungen zwischen den Systemträgern, und

Fig. 7 eine Aufsicht auf ein Systemträgerband mit einer länglichen Ausnehmung zwischen den Systemträgern.

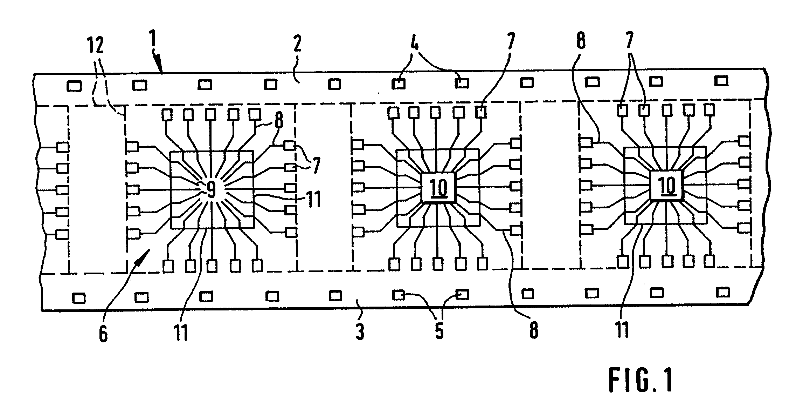

Das in Fig. 1 dargestellte bekannte Systemträgerband besteht aus einem folienartigen Isolierstoffsubstrat 1, das in seinen Randbereichen 2 und 3 jeweils eine Perforierung 4 bzw. 5 zum Transport des Bandes durch die verschiedenen Fertigungseinrichtungen aufweist. Auf dem folienartigen Isolierstoffsubstrat 1 befinden sich in Längsrichtung hintereinander die Systemträger 6.

Jeder Systemträger besteht aus einer Anzahl von elektrisch leitenden, äusseren Anschlussflächen 7 sowie von diesen ausgehenden Leiterbahnen 8, deren Enden 9 die Anschlüsse für die integrierten Schaltkreise 10 bilden. Die Anschlussflächen 7 und die Teile der Leiterbahnen 8, die sich zwischen den Anschlussflächen 7 und den Begrenzungslinien 11 des Substrats erstrecken, stehen in fester Verbindung mit dem folienartigen Isolierstoffsubstrat 1, während die Leiterbahnen von den Begrenzungslinien 11 des Substrats 1 bis zu den Enden 9 keine Verbindung mit dem Substrat 1 haben, da dieses zwischen den Begrenzungslinien 11 entfernt ist.

Die Verbindung der Leiterbahnenden 9 mit den entsprechenden Anschlussflächen auf dem integrierten Schaltkreis 10 erfolgt durch Schweissen in einem einzigen Arbeitsgang. Danach werden die Systemträger 6 mit den aufgebrachten integrierten Stromkreisen 10 entlang den gestrichelten Linien 12 aus dem folienartigen Isolierstoffsubstrat herausgestanzt.

Wie bereits erwähnt, hat sich gezeigt, dass sich die an die entsprechenden Anschlussstellen der integrierten Schaltkreise angeschweissten Leiterbahnenden 9 bei der Weiterbehandlung des Systemträgerbandes bis zum Systemträgerausstanzvorgang wieder lösen können, wobei es sich insbesondere um die etwa in Längsrichtung des Bandes verlaufenden Leiterbahnenden 9 handelt. Um diese Trennung der Leiterbahnenden 9 von ihren entsprechenden Anschlussstellen auf den integrierten Schaltkreisen 10 zu unterbinden, werden zwischen den einzelnen Systemträgern hochflexible Zonen 13 im Systemträgerband vorgesehen. Diese flexiblen Zonen 13 bewirken, dass die Schweissverbindung der Leiterbahnenden mit den entsprechenden Anschlüssen auf dem integrierten Schaltkreis 10 nicht länger eine Trennung dieser Verbindung herbeiführenden Kräften unterworfen ist, die bei der Weiterbehandlung des Systemträgerbandes und insbesondere bei dessen Biegung quer zur Längsrichtung entstehen.

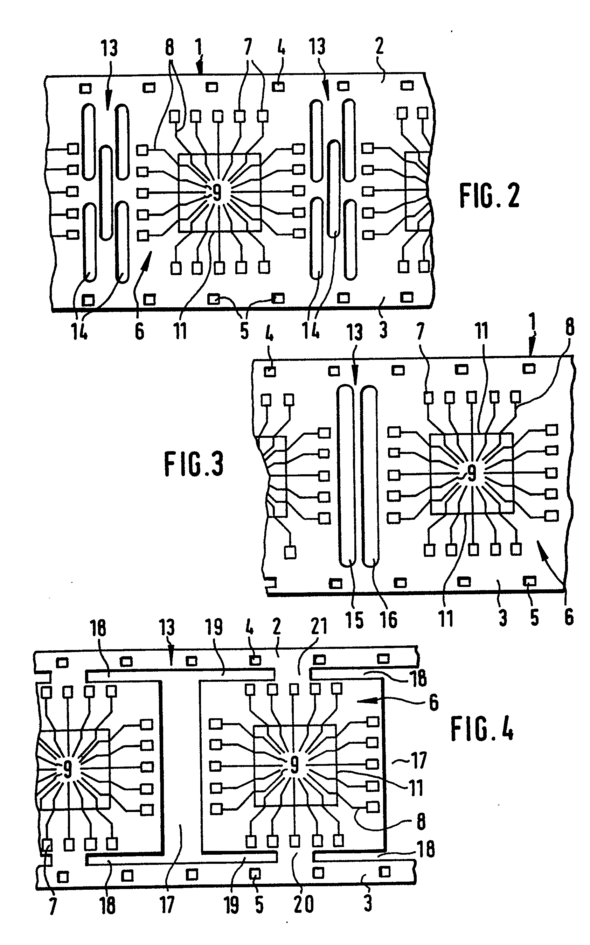

Bei der Ausführungsform nach Fig. 2 sind die hochflexiblen Zonen 13 jeweils durch fünf quer zur Bandlängsachse verlaufende Schlitze 14 realisiert. Die Länge dieser Schlitze ist wesentlich kleiner gewählt als der Abstand der beiden Randbereiche 2 und 3 voneinander. Diese Realisierungsform hat den Vorteil, dass das Systemträgerband 1 während des Fertigungsprozesses verhältnismässig hohen Zugbelastungen ausgesetzt werden kann.

Bei der Ausführungsform nach Fig. 3, bei der die flexible Zone 13 durch zwei zueinander parallele und in Bandlängsrichtung hintereinander angeordnete Ausnehmungen 15 und 16 realisiert ist, ist zwar die Flexibilität des Bandes im Bereich der flexiblen Zone 13 grösser als bei der Ausführungsform nach Fig. 2, jedoch ist die Belastbarkeit eines solchen Systemträgerbandes auf Zugkräfte geringeren Umfangs beschränkt.

Bei der in Fig. 4 dargestellten Ausführungsform

ist schliesslich die Zone 13 durch eine einzige Ausnehmung 17 realisiert, die sich von einem Bandrandbereich 2 bis zum anderen Bandrandbereich 3 erstreckt und an ihren den Bandrandbereichen 2 und 3 benachbarten Enden jeweils in zwei schmale, sich in Längsrichtung des Systemträgerbandes erstreckende Ausnehmungsfortsätze 18 und 19 übergeht. Die Ausnehmungsfortsätze 18 und 19 verlaufen, wie ersichtlich, jeweils zwischen der Bandperforierung 4 und den der Bandperforierung zugewandten Anschlussflächen 7. Jeder Ausnehmungsfortsatz 18 bzw. 19 der einen Ausnehmung 17 bildet mit den Ausnehmungsfortsätzen 19 bzw. 18 der in Bandlängsrichtung folgenden nächsten Ausnehmung 17 eine solche Begrenzung des Systemträgers 6, dass dieser nur noch über zwei schmale, quer zur Bandlängsachse verlaufende Brücken 20 und 21 mit den Bandrandbereichen 2 und 3 des Systemträgerbandes 1 in Verbindung steht.

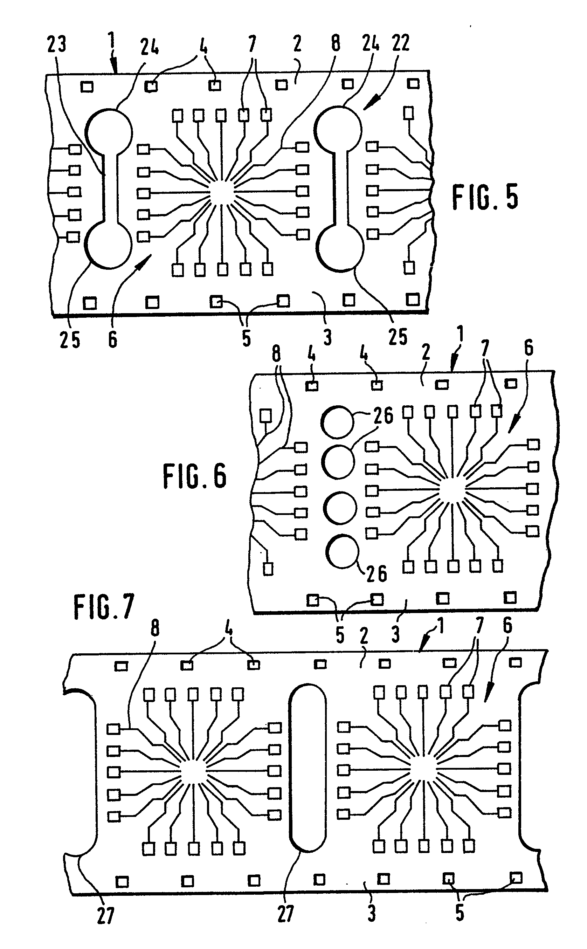

Bei der in Fig. 5 dargestellten Ausführungsform bestehen die Ausnehmungen 22 aus einem schmalen Mittelteil 23, das in endseitige Verbreiterungen 24 bzw. 25 übergeht. Diese Ausführungsform steht hinsichtlich ihrer mechanischen Eigenschaften zwischen der Ausführungsform gemäss Fig. 4 und derjenigen der Fig. 7, bei der lediglich jeweils eine breite Ausnehmung 27 zwischen zwei benachbarten Systemträgern 6 vorhanden ist. Bei der in Fig. 6 dargestellten Ausführungsform sind vier quer zur Bandlängsachse angeordnete kreisförmige Ausnehmungen 26 vorhanden. Ein solches Band kann mit verhältnismässig hohen Zugkräften belastet werden.

## Patentansprüche

1. Systemträgerband mit mehreren mit Abstand in Bandlängsrichtung hintereinander angeordneten Systemträgern für integrierte Schaltkreise, von denen jeder aus einer Anzahl von Leiterbahnen besteht, die sich von einem dem integrierten Schaltkreis zugeordneten inneren Bereich strahlenartig zu einem äusseren, Anschlussflächen aufweisenden Bereich erstrecken, zwischen dem und der ihm benachbarten Bandkante ein dem Transport des Bandes während der Fertigung dienender Bandrandbereich vorhanden ist, dadurch gekennzeichnet, dass zwischen jeweils zwei einander benachbarten Systemträgern (6) und den beiden diesen Systemträgern (6) zugeordneten Bandrandbereichen (2, 3) mindestens eine die Flexibilität des Bandes in diesem Gebiet (13) erhöhende Ausnehmung (14; 15; 16; 17, 18, 19) vorhanden ist.

2. Systemträgerband nach Anspruch 1, dadurch gekennzeichnet, dass zwei oder mehrere quer zur Bandlängsrichtung mit Abstand hintereinander angeordnete Ausnehmungen (14) in dem Gebiet (13) vorhanden sind.

3. Systemträgerband nach einem der Ansprüche 1 oder 2, dadurch gekennzeichnet, dass mindestens zwei zueinander parallele und in Bandlängsrichtung hintereinander angeordnete Ausnehmungen (15, 16) in dem Gebiet (13) vorhanden sind.

4. Systemträgerband nach Anspruch 1, dadurch gekennzeichnet, dass eine einzige Ausnehmung (17) in dem Gebiet (13) vorhanden ist, die sich von Bandrandbereich (2, 3) zu Bandrandbereich (2, 3) und von Systemträger (6) zu Systemträger (6) erstreckt.

5. Systemträgerband nach einem der Ansprüche 1 bis 4, dadurch gekennzeichnet, dass jedes einem Bandrandbereich (2, 3) zugewandte Ende einer Ausnehmung (14; 15, 16; 17) mindestens einen sich etwa in Bandlängsrichtung zwischen den Bandrandbereich (2, 3) und den Systemträger (6) erstreckenden Ausnehmungsfortsatz (18, 19) aufweist.

6. Systemträgerband nach Anspruch 5, dadurch gekennzeichnet, dass die Länge der Ausnehmungsfortsätze (18, 19) dergestalt gewählt ist, dass jeder Systemträger (6) ausschliesslich über zwei schmale, quer zur Bandlängsachse verlaufende Brücken (20, 21) mit den Bandrandbereichen (2, 3) verbunden ist.

7. Systemträgerband nach Anspruch 6, dadurch gekennzeichnet, dass die Brücken (20, 21) etwa mittig zur Systemträgerlänge angeordnet sind.

8. Systemträgerband nach einem der Ansprüche 1 bis 4, dadurch gekennzeichnet, dass jedes einem Bandrandbereich (2, 3) zugewandte Ende einer Ausnehmung (23) verbreitert ist.

## Claims

1. System carrier band having a plurality of system carriers for integrated circuits, said carriers being arranged one behind the other in the longitudinal direction of the band with spacing between each other, and each comprising a plurality of conductor tracks which extend in radiating formation from an inner region associated with the integrated circuit to an outer region which comprises terminal areas and between which and the band edge adjacent to it there is provided a band edge region serving for transporting the band during production, characterised in that between each two mutually adjacent system carriers (6) and the two band edge regions (2, 3) associated with these system carriers (6) there is provided at least one aperture (14; 15, 16; 17, 18, 19) increasing the flexibility of the band in this zone (13).

2. System carrier band according to Claim 1, characterised in that two or more apertures (14) arranged transversely to the longitudinal direction of the band and spaced one behind the other are provided in the zone (13).

3. System carrier band according to Claim 1 or 2, characterised in that at least two apertures (15, 16) which are parallel to one another and situated one after the other in the longitudinal direction of the band are provided in the zone (13).

4. System carrier band according to Claim 1, characterised in that a single aperture (17) is arranged in the zone (13) and extends from band edge region (2, 3) to band edge region (2, 3) and from system carrier (6) to system carrier (6).

5. System carrier band according to one of Claims 1 to 4, characterised in that each end of an aperture (14; 15, 16; 17) which is directed towards a band edge region (2, 3) comprises at least one aperture extension (18, 19) arranged approximately in the longitudinal direction of the band between the band edge region (2, 3) and the system carrier (6).

6. System carrier band according to Claim 5, characterised in that the length of the aperture extensions (18, 19) is so chosen that each system carrier (6) is connected to the band edge regions (2, 3) solely by two narrow bridges (20, 21) which are disposed transversely to the longitudinal axis of the band.

7. System carrier band according to Claim 6, characterised in that the bridges (20, 21) are arranged substantially centrally of the system carrier length.

8. System carrier band according to one of Claims 1 to 4, characterised in that each end of an aperture (23) directed towards a band edge region (2, 3) is widened.

## Revendications

1. Bande porteuse de système comportant plusieurs supports de systèmes disposés à distance les uns derrière les autres dans le sens longitudinal de la bande, pour des circuits intégrés, dont chacun consiste en un certain nombre de pistes conductrices s'étendant de manière rayonnante d'une région interne associée au circuit intégré jusqu'à une région externe présentant des surfaces de raccordement, une région marginale de la bande, servant au transport de cette bande au cours de la fabrication, étant intercalée entre ladite région externe et le bord de ladite bande qui lui est voisin, bande caractérisée par le fait qu'elle comporte à chaque fois, entre deux supports de systèmes (6) mutuellement voisins et les deux régions marginales (2, 3) de cette bande associées auxdits supports de systèmes (6), au moins un évidement (14; 15, 16; 17, 18, 19) augmentant la flexibilité de ladite bande dans cette zone (13).

2. Bande porteuse selon la revendication 1, caractérisée par le fait que deux ou plus de deux évidements (14) perpendiculaires, situés à distance les uns derrière les autres dans le sens longitudinal de la bande, sont présents dans la zone (13).

3. Bande porteuse selon l'une des revendications 1 ou 2, caractérisée par le fait qu'au moins deux évidements (15, 16), mutuellement parallèles et disposés l'un derrière l'autre dans le sens longitudinal de la bande, sont présents dans la zone (13).

4. Bande porteuse selon la revendication 1, caractérisée par le fait qu'il est prévu, dans la zone (13), un seul et unique évidement (17) qui s'étend d'une région marginale (2, 3) de la bande à une autre région marginale (2, 3) de la bande et d'un support de système (6) à un autre support de système (6).

5. Bande porteuse selon l'une des revendications 1 à 4, caractérisée par le fait que chaque extrémité d'un évidement (14; 15, 16; 17) tournée vers une région marginale (2, 3) de la bande présente au moins un prolongement (18, 19) de l'évidement s'étendant sensiblement dans le sens longitudinal de la bande, entre la région marginale (2, 3) de cette bande et le support de système (6).

6. Bande porteuse selon la revendication 5, caractérisée par le fait que la longueur des prolongements (18, 19) des évidements est choisie de telle sorte que chaque support de système (6) soit relié aux régions marginales (2, 3) de la bande exclusivement par l'intermédiaire de deux ponts étroits (20, 21) s'étendant perpendiculairement à l'axe longitudinal de ladite bande.

7. Bande porteuse selon la revendication 6, caractérisée par le fait que les ponts (20, 21) sont disposés approximativement au centre par rapport à la longueur du support de système.

8. Bande porteuse selon l'une des revendications 1 à 4, caractérisée par le fait que chaque extrémité d'un évidement (23) tournée vers une région marginale (2, 3) de ladite bande est élargie.

FIG.1

0 057 253

FIG. 2

FIG. 3

FIG. 4

FIG. 5

FIG. 6

FIG. 7